# EUROPÄISCHE PATENTSCHRIFT

(11) **EP 2 067 185 B1**
(45) Veröffentlichungstag und Bekanntmachung des Hinweises auf die Patenterteilung: **17.11.2010**
(21) Anmeldenummer: 07820299.1
(22) Anmeldetag: 18.09.2007
(51) Int. Cl.: H01L 41/053

(54) **KAPSELUNG EINES PIEZO-AKTORS**
ENCLOSURE OF A PIEZO-ACTUATOR
ENCAPSULAGE D'UN ACTIONNEUR PIÉZOÉLECTRIQUE

(30) Priorität: 26.09.2006 DE 102006045315
(43) Veröffentlichungstag der Anmeldung: 10.06.2009
(73) Patentinhaber: SIEMENS AKTIENGESELLSCHAFT, 80333 München (DE)
(72) Erfinder: BACHMAIER, Georg, 80538 München (DE); GOTTLIEB, Bernhard, 81739 München (DE); GÖDECKE, Andreas, 81675 München (DE); HENNIG, Oliver, 81543 München (DE); LUGERT, Günter, 80804 München (DE); MAGORI, Erhard, 85622 Feldkirchen (DE); MOCK, Randolf, 85662 Hohenbrunn (DE)
(86) Internationale Anmeldenummer: PCT/EP2007/059839
(87) Internationale Veröffentlichungsnummer: WO 2008/037625

(56) Entgegenhaltungen:
- EP-A- 1 079 098
- EP-A- 1 503 246

## Beschreibung

Die Erfindung liegt auf dem technischen Gebiet der Piezo-Aktoren und betrifft eine Kapselung eines Piezo-Aktors, einen gekapselten Piezo-Aktor, sowie ein Verfahren zur Herstellung einer Kapselung eines Piezo-Aktors.

Piezo-Aktoren beruhen auf dem Grundprinzip, dass sich piezoelektrische Materialien, wie Piezo-Keramiken, beim Anlegen einer elektrischen Spannung in ihren räumlichen Abmessungen ändern. Um die nutzbare Längenänderung zu vergrößern, werden häufig eine Mehrzahl keramischer Piezo-Aktoren mit zwischengelagerten Innenelektroden stapelförmig gesintert, wobei die Innenelektroden wechselseitig aus dem Stapel herausgeführt und mit einer Außenmetallisierung verbunden werden. Durch die mechanische Serienschaltung der einzelnen Piezo-Aktoren können vergleichsweise große Längenänderungen in Stapelrichtung bei relativ niedrigen angelegten Spannungen erzielt werden. Um einen Kurzschluss zu vermeiden, wird meist eine Isolierfolie auf die Außenmetallisierung aufgebracht. Zudem wird der Piezo-Aktor gewöhnlich in eine Kunststoffhülle eingebracht, welche mit Silikonmasse ausgegossen wird, die man anschließend aushärten lässt.

Aufgrund ihrer vorteilhaften Eigenschaften, wie verlustarme Steuerung und der Möglichkeit sehr schnelle Positionierungen mit einer Genauigkeit im Nanometerbereich durchzuführen, werden Piezo-Aktoren heutzutage in vielfältigen Anwendungsbereichen eingesetzt.

Eine besonders wichtige Anwendung finden Piezo-Aktoren beispielsweise in selbstzündenden Brennkraftmaschinen, wo sie in Kraftstoff-Injektoren zum Betätigen von Einspritzventilen zum Einspritzen von Kraftstoff in den Brennraum der Brennkraftmaschine eingesetzt werden. In neueren Kraftstoff-Injektoren sind die Piezo-Aktoren hierbei vollständig von Kraftstoff umgeben, mit der Folge, dass sie vor dem damit einher gehenden chemischen Angriff geschützt werden müssen. So ist bekannt, dass die keramischen Materialien der Piezo-Aktoren von verunreinigtem und/oder mit Additiven versetztem Kraftstoff chemisch angegriffen werden.

Um Piezo-Aktoren vor einem solchen chemischen Angriff zu schützen, werden diese gewöhnlich mit einer zusätzlichen Metallhülse umgeben, die mit geeigneten Füllmaterialien, wie Silikonmasse, verfüllt wird. Derartige Metallhülsen sind während des Betriebs der Brennkraftmaschine enormen physikalischen Einwirkungen unterworfen. So treten vergleichsweise große Temperaturänderungen von beispielsweise bis zu 200°C auf, wenn die Brennkraftmaschine zwischen einem kalten Nichtbetriebs-Zustand und einem heißen Betriebszustand wechselt, was zu großen thermischen Volumenänderungen der Metallhülse und dessen Füllmaterial führt. Zudem muss das von Kraftstoff umgebene Metallgehäuse, aufgrund des hohen Einspritzdrucks moderner Brennkraftmaschinen, Druckunterschiede von bis zu 2000 bar ausgleichen können. Moderne Injektoren basieren auf einem isobaren Aktorkonzept. Hierbei wird der Aktor unter vollem Kraftstoffdruck betrieben. Daher muss die Aktorkapselung druckweich ausgeführt werden, das heißt ein Druckabfall beziehungsweise eine Druckdifferenz über der Kapselmembran ist zu vermeiden.

Die elastischen Eigenschaften der Metallhülse der Piezo-Aktoren müssen demnach sehr hohen Anforderungen genügen, die jedoch im Allgemeinen nur unzureichend erfüllt werden können. Da alternative Materialien auf Basis von Kunststoffen oder Polymeren nicht völlig diffusionsdicht sind, kommen derzeit nur metallische Körper zur Verkapselung der Piezo-Aktoren in Betracht.

Beispiele in Stand der Technik sind EP1503246 und EP1079098.

Demnach besteht die Aufgabe der vorliegenden Erfindung darin, eine Kapselung für einen Piezo-Aktor zur Verfügung zu stellen, welche einerseits den Piezo-Aktor vor chemischem Angriff schützt und andererseits physikalischen Einwirkungen, wie sie in der Kraftstoffzuführung von selbstzündenden Brennkraftmaschinen auftreten können, standhält.

Diese Aufgabe wird nach dem Vorschlag der Erfindung durch eine Kapselung eines Piezo-Aktors mit den Merkmalen von Anspruch 1 gelöst. Vorteilhafte Ausgestaltungen der Erfindung sind durch die Merkmale der Unteransprüche angegeben.

Erfindungsgemäß ist eine Kapselung eines Piezo-Aktors gezeigt, welche sich in wesentlicher Weise dadurch auszeichnet, dass sie wenigstens zwei, insbesondere unmittelbar benachbarte (angrenzende) Kapselungsabschnitte umfasst, die in Axialrichtung, das heißt parallel zu einer Längsachse des Piezo-Aktors, versetzt und jeweils wellenförmig mit mehreren parallel zueinander angeordneten Wellen ausgebildet sind, wobei die Wellen der Kapselungsabschnitte in einem (von Null verschiedenen) Winkel zueinander verlaufen.

Die durch piezoelektrischen Effekt bewirkten Längenänderungen des Piezo-Aktors erfolgen entlang der "Längsachse" des Piezo-Aktors. Die Längsachse (Axialrichtung) des Piezo-Aktors entspricht gleichermaßen einer Längsachse (Axialrichtung) der Kapselung.

Durch die erfindungsgemäße Gestaltung der Kapselung mit verschiedenen Kapselungsabschnitten, deren Wellen in einem (von Null verschiedenen) Winkel zueinander verlaufen, können die elastischen Eigenschaften der Kapselung in radialer Richtung und axialer Richtung in gewünschter Weise eingestellt werden.

Hierbei ist es besonders vorteilhaft, wenn die radial auswärts ragenden Wellenberge einen relativ geringen Verrundungsradius und die radial einwärts ragenden Wellentäler einen relativ großen Verrundungsradius haben, wodurch einerseits eine vergleichsweise hohe Elastizität der Kapselung in radialer Richtung und andererseits ein relativ geringes Totvolumen zwischen Kapselung und Piezo-Aktor erreicht werden kann.

Bei einer vorteilhaften ersten Ausführungsform der erfindungsgemäßen Kapselung umfasst diese wenigstens zwei benachbarte Kapselungsabschnitte, nämlich einen Kapselungsabschnitt, bei welchem die Wellen in Axialrichtung ausgebildet sind, und einen Kapselungsabschnitt, bei welchem die Wellen in Umfangsrichtung, das heißt senkrecht zur Längsachse des Piezo-Aktors, ausgebildet sind. Diese beiden Kapselungsabschnitte können insbesondere mehrfach in periodischer Weise in Axialrichtung des Piezo-Aktors angeordnet sein.

Gemäß einer vorteilhaften Ausgestaltung der ersten Ausführungsform der erfindungsgemäßen Kapselung, ist es für den Fall, dass die Kapselung genau zwei solche Kapselungsabschnitte aufweist, besonders vorteilhaft, wenn jener Kapselungsabschnitt, bei dem die Wellen in Umfangsrichtung ausgebildet sind, auf der Seite eines Loslagers des Piezo-Aktors angeordnet ist.

Bei einer weiteren vorteilhaften Ausgestaltung der ersten Ausführungsform der erfindungsgemäßen Kapselung haben der Kapselungsabschnitt, bei welchem die Wellen in Axialrichtung ausgebildet sind, und der Kapselungsabschnitt, bei welchem die Wellen in Umfangsrichtung ausgebildet sind, in Axialrichtung des Piezo-Aktors bemessene Längen mit einem Längenverhältnis von ca. 4:1.

Bei einer vorteilhaften zweiten Ausführungsform der erfindungsgemäßen Kapselung umfasst diese wenigstens zwei benachbarte Kapselungsabschnitte, welche jeweils mit den Piezo-Aktor in Axialrichtung schraubenförmig umgebenden Wellen ausgebildet sind. Hierbei haben die Wellen in den beiden Kapselungsabschnitten eine voneinander verschiedene Gangrichtung, das heißt, wenn der eine Kapselungsabschnitt eine linksgängige Schraube formende Wellen aufweist, weist der andere Kapselungsabschnitt eine rechtsgängige Schraube formende Wellen auf, und umgekehrt. Diese beiden Kapselabschnitte mit wechselnder Gangrichtung der schraubenförmigen Wellen können insbesondere mehrmals in einer periodischen Abfolge entlang der Axialrichtung des Piezo-Aktors angeordnet sein.

. Eine Kapselung mit schraubenförmiger Wellenstruktur ist in der Lage sowohl axiale als auch radiale Bewegungen elastisch zuzulassen. Die Erzeugung eines Drehmoments bei einer Formänderung der Kapselung kann durch die Kombination der beiden Kapselungsabschnitte mit gegenläufigen schraubenförmigen Wellen vermieden werden. Die Steigung der schraubenförmig angeordneten Wellen bestimmt für jeden Kapselungsabschnitt die relativen Elastizitäten in axialer und radialer Richtung und kann dem Anwendungsfall entsprechend ausgelegt werden.

Gemäß einer vorteilhaften Ausgestaltung der zweiten Ausführungsform der erfindungsgemäßen Kapselung nehmen die Wellen einen Winkel zur Axialrichtung des Piezo-Aktors ein, welcher in einem Winkelbereich von 10°-30° liegt und insbesondere 25° beträgt, so dass die Elastizität der Kapselung in radialer Richtung größer als deren Elastizität in axialer Richtung ist.

Gemäß einer weiteren vorteilhaften Ausgestaltung der zweiten Ausführungsform der erfindungsgemäßen Kapselung haben die schraubenförmigen Wellen in den beiden benachbarten Kapselungsabschnitten eine unterschiedliche Ganghöhe. Alternativ hierzu können die schraubenförmigen Wellen in den beiden benachbarten Kapselungsabschnitten eine gleiche Ganghöhe haben.

In der erfindungsgemäßen Kapselung können die einzelnen Wellen voneinander gleich oder verschieden beabstandet sein. Weiterhin können die verschiedenen Kapselungsabschnitte einteilig oder mehrteilig ausgebildet sein.

Die erfindungsgemäße Kapselung ist vorteilhaft aus einem metallischen Material, wie beispielsweise Federstahl oder Aluminium, gefertigt.

Die erfindungsgemäße Kapselung kann insbesondere in Form eines hülsenförmigen Hohlkörpers ausgebildet sein. Gleichermaßen ist es jedoch auch möglich, dass sie lediglich in Form einer Außenschicht auf einen Piezo-Aktor aufgebracht ist.

Die Erfindung erstreckt sich ferner auf Verfahren zur Herstellung einer Kapselung eines wie oben beschriebenen Piezo-Aktors. Hierbei kann die Kapselung mittels eines hydrostatischen Umformprozesses hergestellt werden. Alternativ hierzu kann die Kapselung in einem Wälzprägeverfahren hergestellt werden. Weiterhin alternativ, für den Fall, dass der Piezo-Aktor als Formteil ausgebildet wird, kann die Kapselung beispielsweise galvanisch als eine Außenschicht auf den Piezo-Aktor abgeschieden werden.

Weiterhin erstreckt sich die Erfindung auf einen Hochdruckaktor mit einem Piezo-Aktor und einer den Piezo-Aktor umgebenden (kapselnden) Kapselung, wie sie weiter oben beschrieben worden ist.

Die Erfindung wird nun anhand zweier Ausführungsbeispiele näher erläutert, wobei Bezug auf die beigefügten Figuren genommen wird. Gleiche oder gleich wirkende Elemente sind in den Figuren mit den gleichen Bezugszeichen bezeichnet.
Fig. 1 zeigt in schematischer Weise ein erstes Ausführungsbeispiel der erfindungsgemäßen Kapselung eines Piezo-Aktors;
Fig. 2 zeigt in schematischer Weise ein zweites Ausführungsbeispiel der erfindungsgemäßen Kapselung eines Piezo-Aktors.
Fig. 3 zeigt in schematischer Weise eine Ausgestaltung der Wellen in der erfindungsgemäßen Kapselung eines Piezo-Aktors.

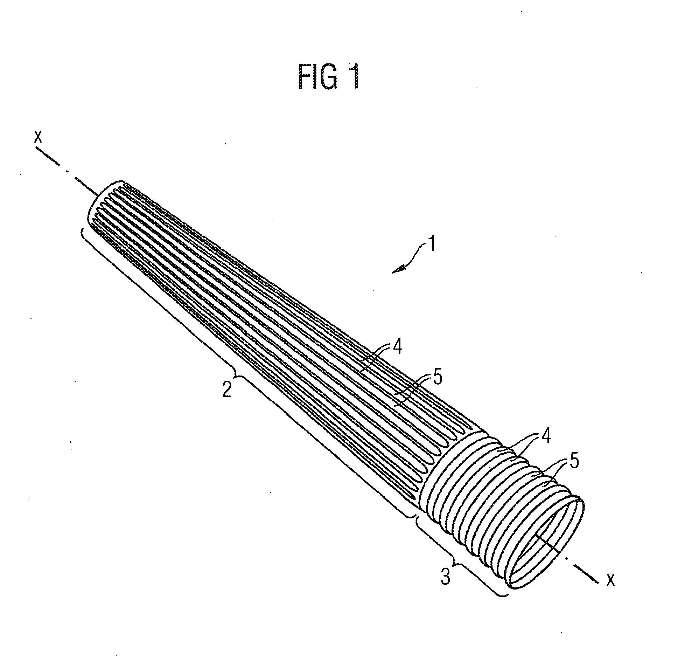

Sei zunächst Fig. 1 betrachtet. In Fig. 1 ist ein Ausführungsbeispiel einer Kapselung eines Piezo-Aktors in schematischer Weise dargestellt. Die Kapselung, welche insgesamt mit der Bezugszahl 1 bezeichnet ist, ist in Form eines im Wesentlichen zylindrischen Hohlkörpers mit der Längsmittenachse X-X ausgebildet. Die Axialrichtung des Hohlkörpers verläuft parallel zu dessen Längsmittenachse X-X. Ferner entspricht die Längsmittenachse X-X einer Hubrichtung des von der Kapselung 1 gekapselten Piezo-Aktors. Der Hohlkörper ist aus einem metallischen Material, beispielsweise Federstahl oder Aluminium, gefertigt.

Die Kapselung 1 (beziehungsweise der Kapselmantel) umfasst zwei Kapselungsabschnitte 2, 3, die jeweils mit einer wellenförmigen Struktur versehen sind, welche mehrere parallel zueinander angeordnete Wellen umfasst. Jede Welle enthält einen radial auswärts sich erstreckenden Wellenberg 4 und ein radial einwärts sich erstreckendes Wellental 5. Die Wellentäler 5 ragen somit als "Wellenberge" in den umgrenzten Innenraum des Hohlkörpers.

Die Wellen der beiden Kapselungsabschnitte 2, 3 verlaufen in einem Winkel von ca. 90° zueinander. Hierbei erstrecken sich die Wellen des Kapselungsabschnitts 2 parallel zur Axialrichtung der Kapselung 1, während sich die Wellen des Kapselungsabschnitts 3 senkrecht zur Axialrichtung der Kapselung 1 (das heißt parallel zur Umfangsrichtung der zylindrischen Kapselung 1) erstrecken. Das Verhältnis der in Längsmittenrichtung X-X bemessenen Längen des Kapselungsabschnitts 2 zum Kapselabschnitt 3 beträgt ca. 4:1. Hierdurch kann in vorteilhafter Weise erreicht werden, dass die Kapselung 1 stärker in radialer Richtung als in deren axialen Richtung elastisch verformbar ist, was dem gewöhnlicher Weise relativ geringen Hub in Axialrichtung des Piezo-Aktors entspricht. Benachbarte Wellen der beiden Kapselungsabschnitte weisen in etwa einen gleichen Abstand voneinander auf. Der Kapselabschnitt 3, dessen Wellen parallel zur Umfangsrichtung verlaufen, wird vorteilhaft auf der Seite eines Loslagers des Piezo-Aktors angeordnet.

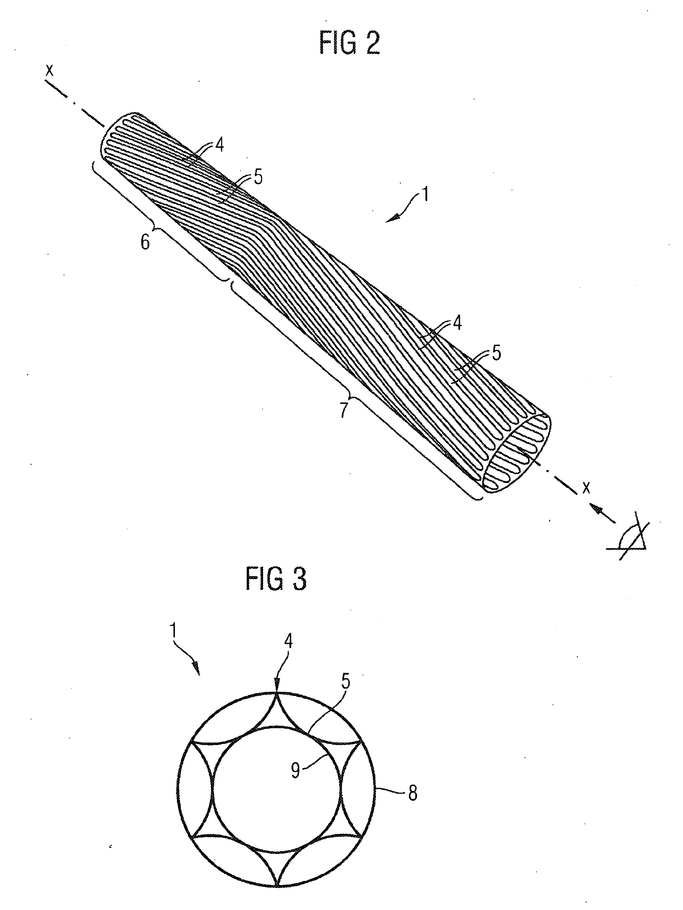

Sei nun Fig. 2 betrachtet, worin in schematischer Weise ein weiteres Ausführungsbeispiel der Kapselung eines Piezo-Aktors dargestellt ist. Um unnötige Wiederholungen zu vermeiden, werden lediglich die Unterschiede zum Ausführungsbeispiel von Fig. 1 erläutert und ansonsten wird auf die zu Fig. 1 gemachten Ausführungen Bezug genommen.

Das Ausführungsbeispiel der Kapselung 1 eines Piezo-Aktors von Fig. 2 unterscheidet sich von dem Ausführungsbeispiel von Fig. 1 dahingehend, dass zwei Kapselungsabschnitt 6, 7 vorgesehen sind, deren Wellenstruktur sich von der Wellenstruktur der Kapselungsabschnitte 2, 3 von Fig. 1 unterscheidet. Die beiden Kapselungsabschnitte 6, 7 von Fig. 2 sind jeweils mit den Piezo-Aktor, beziehungsweise die Längsmittenachse X-X, schraubenförmig umgebenden Wellen ausgebildet, wobei die Wellen in den beiden Kapselungsabschnitten 6, 7 eine unterschiedliche Gangrichtung haben. So formen, bezogen auf die in Fig. 2 angegebene Blickrichtung entlang der Längsmittenachse X-X, die Wellen des Kapselungsabschnitts 7 eine rechtsgängige Schraube, deren Wellen die Längsmittenachse X-X im Uhrzeigersinn umlaufen, während die Wellen des Kapselungsabschnitts 6 eine linksgängige Schraube formen, deren Wellen die Längsmittenachse X-X im Gegenuhrzeigersinn umlaufen. Hierbei nehmen die Wellen beider Kapselungsabschnitte 6, 7 zur Axialrichtung der Kapselung 1 jeweils einen Winkel von ca. 25° ein.

Durch den von den Wellen eingenommenen Winkel zur Axialrichtung der Kapselung 1 kann die elastische Verformbarkeit in radialer Richtung beziehungsweise in einer Richtung parallel zur Umfangsrichtung der Kapselung 1 in gewünschter Weise eingestellt werden: Je kleiner der von den Wellen zur Axialrichtung der Kapselung 1 eingenommene Winkel ist, desto größer ist die elastische Verformbarkeit der Kapselung 1 in radialer Richtung und desto kleiner ist die elastische Verformbarkeit der Kapselung 1 in einer Richtung parallel zur Umfangsrichtung der Kapselung 1. Andererseits, je größer der von den Wellen zur Axialrichtung der Kapselung 1 eingenommene Winkel ist, desto kleiner ist die elastische Verformbarkeit der Kapselung 1 in radialer Richtung und desto größer ist die elastische Verformbarkeit der Kapselung 1 in einer Richtung parallel zur Umfangsrichtung der Kapselung 1.

In dem gezeigten Ausführungsbeispiel von Fig. 2 haben die die Längsmittenachse X-X schraubenförmig umgebenden Wellen in den beiden Kapselungsabschnitten 6, 7 eine in etwa gleiche Ganghöhe. Die beiden Kapselungsabschnitte 6, 7 haben in etwa eine gleiche in Axialrichtung des Piezo-Aktors bemessene Länge.

Die Erzeugung eines Drehmoments bei einer elastischen Formänderung der Kapselung 1 kann durch die Kombination der beiden Kapselungsabschnitte 6, 7 mit gegenläufigen schraubenförmigen Wellen vermieden werden.

Es wird nun Bezug auf Fig. 3 genommen, worin in einer Querschnittsdarstellung senkrecht zur Axialrichtung eine Ausgestaltung der erfindungsgemäßen Kapselungen von Fig. 1 und Fig. 2 dargestellt ist. Demnach weisen die radial auswärts sich erstreckenden Wellenberge 4 der Wellen einen relativ kleinen Verrundungsradius auf, so dass die Wellen eher "zugespitzt" sind. Die Spitzen der Wellenberge 4 sind von einer Kreisform 8 umhüllt. Andererseits schmiegen sich die Wellentäler 5 mit einem relativ großen Verrundungsradius (größerer Verrundungsradius als die Wellenberge) einer dem zylindrischen Hohlkörper eingeschriebenen Kreisform 9 an, so dass die als "Wellenberge" in den Innenraum des Hohlkörpers ragenden Wellentäler 5 "verbreitert" sind. Hierdurch kann in vorteilhafter Weise eine vergleichsweise hohe radiale Flexibilität bei einem gleichzeitig vergleichsweise geringen, durch die Wellung eingebrachten Totvolumen zwischen Kapselung und Piezo-Aktor erzielt werden.

Mittels der erfindungsgemäßen Kapselung kann der Piezo-Aktor in besonders vorteilhafter Weise in einem Kraftstoff-Injektor einer selbstzündenden Brennkraftmaschine eingesetzt werden. Hierdurch kann der Piezo-Aktor in jeder Art Kraftstoff über einen sehr großen Temperaturbereich betrieben werden, wobei selbst der Einsatz in Wasserstoff mit seiner stark reduzierenden Eigenschaft ermöglicht ist. Die am Piezo-Aktor anliegenden Kraftstoffdrücke können isobar von allen Seiten übertragen werden, so dass eine Betätigung des Piezo-Aktors entgegen einem anliegenden Kraftstoffdruck vermieden werden kann. Durch die isobare Druckbelastung kann eine Verkürzung des Piezo-Aktors bei Aufbau des Kraftstoffdrucks weitestgehend vermieden werden. Die Anforderungen an die axialen Kompensationselemente des Kraftinjektors fallen demzufolge geringer aus. Volumenänderungen der Einheit aus Aktor und Membran können direkt vom Kraftstoffvolumen aufgenommen werden, ohne die Funktion des Kraftstoff-Injektors zu beeinflussen.

### Bezugszeichenliste

- 1: Kapselung
- 2: Kapselungsabschnitt
- 3: Kapselungsabschnitt
- 4: Wellenberg
- 5: Wellental
- 6: Kapselungsabschnitt
- 7: Kapselungsabschnitt
- 8: äußere Kreisform
- 9: innere Kreisform

## Patentansprüche

1. Kapselung (1) eines Piezo-Aktors, **dadurch gekennzeichnet, dass** sie wenigstens zwei in Axialrichtung (X-X), parallel zu einer Längsachse des Piezo-Aktors, versetzte Kapselungsabschnitte (2, 3; 6, 7) aufweist, welche jeweils wellenförmig mit mehreren parallel zueinander angeordneten Wellen (4, 5) ausgebildet sind, wobei die Wellen der Kapselungsabschnitte in einem von Null verschiedenen Winkel zueinander verlaufen.

2. Kapselung nach Anspruch 1, **dadurch gekennzeichnet, dass** sie wenigstens zwei benachbarte Kapselungsabschnitte umfasst, nämlich einen Kapselungsabschnitt (2), bei welchem die Wellen (4, 5) in Axialrichtung ausgebildet sind, und einen Kapselungsabschnitt (3), bei welchem die Wellen (4, 5) in Umfangsrichtung, senkrecht zur Längsachse des Piezo-Aktors ausgebildet sind.

3. Kapselung nach Anspruch 2, **gekennzeichnet durch** eine periodische Abfolge der beiden benachbarten Kapselungsabschnitte in Axialrichtung des Piezo-Aktors.

4. Kapselung nach Anspruch 2, **gekennzeichnet durch** genau zwei Kapselungsabschnitte, wobei der Kapselungsabschnitt (3), bei welchem die Wellen in Umfangsrichtung ausgebildet sind, auf der Seite eines Loslagers des Piezo-Aktors angeordnet ist.

5. Kapselung nach einem der Ansprüche 2 bis 4, **dadurch gekennzeichnet, dass** der Kapselungsabschnitt (2), bei welchem die Wellen in Axialrichtung ausgebildet sind, und der Kapselungsabschnitt (3), bei welchem die Wellen in Umfangsrichtung ausgebildet sind, in Axialrichtung des Piezo-Aktors bemessene Längen mit einem Längenverhältnis von ca. 4:1 haben.

6. Kapselung nach Anspruch 1, **dadurch gekennzeichnet, dass** sie wenigstens zwei benachbarte Kapselungsabschnitte (6, 7) aufweist, welche jeweils mit den Piezo-Aktor in Axialrichtung schraubenförmig umgebenden Wellen (4, 5) ausgebildet sind, wobei die Wellen in den beiden Kapselungsabschnitten eine unterschiedliche Gangrichtung haben.

7. Kapselung nach Anspruch 6, **gekennzeichnet durch** eine periodische Abfolge der beiden benachbarten Kapselungsabschnitte in Axialrichtung des Piezo-Aktors.

8. Kapselung nach einem der Ansprüche 6 bis 7, **dadurch gekennzeichnet, dass** die Wellen einen Winkel zur Axialrichtung (X-X) des Piezo-Aktors einnehmen, welcher in einem Winkelbereich von 10°-30° liegt.

9. Kapselung nach einem der Ansprüche 6 bis 8, **dadurch gekennzeichnet, dass** die Wellen in den beiden benachbarten Kapselungsabschnitten eine unterschiedliche Ganghöhe haben.

10. Kapselung nach einem der Ansprüche 6 bis 8, **dadurch gekennzeichnet, dass** die Wellen in den beiden benachbarten Kapselungsabschnitten eine gleiche Ganghöhe haben.

11. Kapselung nach einem der Ansprüche 6 bis 10, **dadurch gekennzeichnet, dass** die benachbarten Kapselungsabschnitte mit verschiedener Gangrichtung in Axialrichtung des Piezo-Aktors bemessene Längen mit einem Längenverhältnis von ca. 1:1 haben.

12. Kapselung nach einem der vorhergehenden Ansprüche 1 bis 11, **dadurch gekennzeichnet, dass** die einzelnen Wellen voneinander gleich beabstandet sind.

13. Kapselung nach einem der vorhergehenden Ansprüche 1 bis 11, **dadurch gekennzeichnet, dass** die einzelnen Wellen voneinander verschieden beabstandet sind.

14. Kapselung nach einem der vorhergehenden Ansprüche 1 bis 13, **dadurch gekennzeichnet, dass** die Kapselungsabschnitte einteilig ausgebildet sind.

15. Kapselung nach einem der vorhergehenden Ansprüche 1 bis 13, **dadurch gekennzeichnet, dass** die Kapselungsabschnitte mehrteilig ausgebildet sind.

16. Kapselung nach einem der vorhergehenden Ansprüche 1 bis 15, **dadurch gekennzeichnet, dass** die radial auswärts sich erstreckenden Wellenberge (4) einen relativ kleinen Verrundungsradius und die radial einwärts sich erstreckenden Wellentäler (5) einen relativ großen Verrundungsradius aufweisen.

17. Kapselung nach einem der vorhergehenden Ansprüche 1 bis 16, **dadurch gekennzeichnet, dass** sie aus einem metallischen Material gefertigt ist.

18. Kapselung nach einem der vorhergehenden Ansprüche 1 bis 17, **dadurch gekennzeichnet, dass** sie in Form eines hülsenförmigen Hohlkörpers ausgebildet ist.

19. Hochdruckaktor mit einem Piezo-Aktor und einer den Piezo-Aktor umgebenden Kapselung nach einem der Ansprüche 1 bis 18.

20. Verfahren zur Herstellung einer Kapselung eines Piezo-Aktors nach einem der Ansprüche 1 bis 18, **dadurch gekennzeichnet, dass** die Kapselung mittels eines hydrostatischen Umformprozesses hergestellt wird.

21. Verfahren zur Herstellung einer Kapselung eines Piezo-Aktors nach einem der Ansprüche 1 bis 18, **dadurch gekennzeichnet, dass** die Kapselung in einem Wälzprägeverfahren hergestellt wird.

22. Verfahren zur Herstellung einer Kapselung eines Piezo-Aktors nach einem der Ansprüche 1 bis 18, **dadurch gekennzeichnet, dass** der Piezo-Aktor als Formteil ausgebildet wird und auf dem Formteil galvanisch eine den Piezo-Aktor kapselnde Außenschicht abgeschieden wird.

## Claims

1. Enclosure (1) of a piezo actuator, **characterised in that** it has at least two enclosure sections (2, 3; 6, 7) offset in the axial direction (X-X), parallel to a longitudinal axis of the piezo actuator, said enclosure sections each being configured in an undulating manner with multiple undulations (4, 5) arranged in parallel to each other, the undulations of the enclosure sections extending at an angle to one another which is not zero.

2. Enclosure according to claim 1, **characterised in that** it comprises at least two adjacent enclosure sections, namely an enclosure section (2) in which the undulations (4, 5) are configured in the axial direction, and an enclosure section (3) in which the undulations (4, 5) are configured in the circumferential direction, perpendicular to the longitudinal axis of the piezo actuator.

3. Enclosure according to claim 2, **characterised by** a periodic sequence of the two adjacent enclosure sections in the axial direction of the piezo actuator.

4. Enclosure according to claim 2, **characterised by** precisely two enclosure sections, the enclosure section (3) in which the undulations are configured in the circumferential direction being arranged on the side of a floating bearing of the piezo actuator.

5. Enclosure according to one of claims 2 to 4, **characterised in that** the enclosure section (2) in which the undulations are configured in the axial direction and the enclosure section (3) in which the undulations are configured in the circumferential direction have lengths with a length ratio of approx. 4:1 dimensioned in the axial direction of the piezo actuator.

6. Enclosure according to claim 1, **characterised in that** it has at least two adjacent enclosure sections (6, 7) which are each configured with undulations (4, 5) surrounding the piezo actuator helically in the axial direction, the undulations having a different thread direction in the two enclosure sections.

7. Enclosure according to claim 6, **characterised by** a periodic sequence of the two adjacent enclosure sections in the axial direction of the piezo actuator.

8. Enclosure according to one of claims 6 to 7, **characterised in that** the undulations assume an angle to the axial direction (X-X) of the piezo actuator which lies in an angular range of 10°-30°.

9. Enclosure according to one of claims 6 to 8, **characterised in that** the undulations have a different thread height in the two adjacent enclosure sections.

10. Enclosure according to one of claims 6 to 8, **characterised in that** the undulations have an identical thread height in the two adjacent enclosure sections.

11. Enclosure according to one of claims 6 to 10, **characterised in that** the adjacent enclosure sections with a different thread direction have lengths with a length ratio of approx. 1:1 dimensioned in the axial direction of the piezo actuator.

12. Enclosure according to one of the preceding claims 1 to 11, **characterised in that** the individual undulations are equally spaced from one another.

13. Enclosure according to one of the preceding claims 1 to 11, **characterised in that** the individual undulations are differently spaced from one another.

14. Enclosure according to one of the preceding claims 1 to 13, **characterised in that** the enclosure sections are configured as a single piece.

15. Enclosure according to one of the preceding claims 1 to 13, **characterised in that** the enclosure sections are configured in multiple pieces.

16. Enclosure according to one of the preceding claims 1 to 15, **characterised in that** the undulation peaks (4) extending radially outwards have a relatively small rounding radius and the undulation troughs (5) extending radially inwards have a relatively large rounding radius.

17. Enclosure according to one of the preceding claims 1 to 16, **characterised in that** it is manufactured from a metallic material.

18. Enclosure according to one of the preceding claims 1 to 17, **characterised in that** it is configured in the form of a sleeve-shaped hollow body.

19. High-pressure actuator having a piezo actuator and an enclosure surrounding the piezo actuator according to one of claims 1 to 18.

20. Method for manufacturing an enclosure of a piezo actuator according to one of claims 1 to 18, **characterised in that** the enclosure is manufactured by means of a hydrostatic transformation process.

21. Method for manufacturing an enclosure of a piezo actuator according to one of claims 1 to 18, **characterised in that** the enclosure is manufactured in a roller marking process.

22. Method for manufacturing an enclosure of a piezo actuator according to one of claims 1 to 18, **characterised in that** the piezo actuator is configured as a moulded part and an outer layer enclosing the piezo actuator is galvanically deposited on the moulded part.

## Revendications

1. Encapsulage (1) d'un actionneur piézoélectrique **caractérisé en ce qu'**il présente au moins deux parties d'encapsulage (2, 3 ; 6 ; 7) décalées dans le sens axial (X-X), parallèlement à un axe longitudinal de l'actionneur piézoélectrique, lesquelles parties sont respectivement conçues ondulées avec plusieurs ondulations (4, 5) disposées parallèle les unes par rapport aux autres, les ondulations des parties d'encapsulage s'étendant les unes par rapport aux autres dans un angle différent de zéro.

2. Encapsulage selon la revendication 1, **caractérisé en ce qu'**il comporte au moins deux parties d'encapsulage voisines, à savoir une partie d'encapsulage (2), sur laquelle les ondulations (4, 5) sont conçues dans le sens axial, et une partie d'encapsulage (3), sur laquelle les ondulations (4, 5) sont conçues dans le sens périphérique, perpendiculairement à l'axe longitudinal de l'actionneur piézoélectrique.

3. Encapsulage selon la revendication 2, **caractérisé par** une succession périodique des deux parties d'encapsulage voisines dans le sens axial de l'actionneur piézoélectrique.

4. Encapsulage selon la revendication 2, **caractérisé par** exactement deux parties d'encapsulage, la partie d'encapsulage (3), sur laquelle les ondulations sont conçues dans le sens périphérique, étant disposée sur le côté d'un palier libre de l'actionneur piézoélectrique.

5. Encapsulage selon l'une quelconque des revendications 2 à 4, **caractérisé en ce que** la partie d'encapsulage (2), sur laquelle les ondulations sont conçues dans le sens radial, et la partie d'encapsulage (3), sur laquelle les ondulations sont conçues dans le sens périphérique, ont des longueurs dimensionnées dans le sens axial de l'actionneur piézoélectrique avec un rapport de longueurs d'environ 4:1.

6. Encapsulage selon la revendication 1, **caractérisé en ce qu'**il présente au moins deux parties d'encapsulage (6, 7) voisines, lesquelles sont conçues respectivement avec des ondulations (4, 5) entourant à la façon d'une vis l'actionneur piézoélectrique dans le sens axial, les ondulations ayant un sens de pas différent dans les deux parties d'encapsulage.

7. Encapsulage selon la revendication 6, **caractérisé par** une succession périodique des deux parties d'encapsulage voisines dans le sens axial de l'actionneur piézoélectrique.

8. Encapsulage selon l'une quelconque des revendications 6 à 7, **caractérisé en ce que** les ondulations prennent un angle par rapport au sens axial (X-X) de l'actionneur piézoélectrique qui se situe dans une plage d'angle de 10° à 30°.

9. Encapsulage selon l'une quelconque des revendications 6 à 8, **caractérisé en ce que** les ondulations ont une hauteur de pas différente dans les deux parties d'encapsulage voisines.

10. Encapsulage selon l'une quelconque des revendications 6 à 8, **caractérisé en ce que** les ondulations ont une hauteur de pas identique dans les deux parties d'encapsulage voisines.

11. Encapsulage selon l'une quelconque des revendications 6 à 10, **caractérisé en ce que** les parties d'encapsulage voisines ont des longueurs dimensionnées avec un sens de pas différent dans le sens axial de l'actionneur piézoélectrique avec un rapport de longueurs d'environ 1:1.

12. Encapsulage selon l'une quelconque des revendications précédentes 1 à 11, **caractérisé en ce que** les différentes ondulations sont espacées de façon identique les unes des autres.

13. Encapsulage selon l'une quelconque des revendications précédentes 1 à 11, **caractérisé en ce que** les différentes ondulations sont espacées de façon différente les unes des autres.

14. Encapsulage selon l'une quelconque des revendications précédentes 1 à 13, **caractérisé en ce que** les parties d'encapsulage sont conçues d'une seule pièce.

15. Encapsulage selon l'une quelconque des revendications précédentes 1 à 13, **caractérisé en ce que** les parties d'encapsulage sont conçues en plusieurs parties.

16. Encapsulage selon l'une quelconque des revendications précédentes 1 à 15, **caractérisé en ce que** les sommets d'ondulation (4) s'étendant radialement vers l'extérieur présentent un rayon d'arrondi relativement petit et les creux d'ondulation (5) s'étendant radialement vers l'intérieur présentent un rayon d'arrondi relativement grand.

17. Encapsulage selon l'une quelconque des revendications précédentes 1 à 16, **caractérisé en ce qu'**il est fabriqué dans un matériau métallique.

18. Encapsulage selon l'une quelconque des revendications précédentes 1 à 17, **caractérisé en ce qu'**il est conçu sous la forme d'un corps creux en forme de douille.

19. Actionneur à haute pression comprenant un actionneur piézoélectrique et un encapsulage entourant l'actionneur piézoélectrique selon l'une quelconque des revendications 1 à 18.

20. Procédé pour fabriquer un encapsulage d'un actionneur piézoélectrique selon l'une quelconque des revendications 1 à 18, **caractérisé en ce que** l'encapsulage est fabriqué au moyen d'un processus de déformation hydrostatique.

21. Procédé pour fabriquer un encapsulage d'un actionneur piézoélectrique selon l'une quelconque des revendications 1 à 18, **caractérisé en ce que** l'encapsulage est fabriqué dans un procédé de gaufrage.

22. Procédé pour fabriquer un encapsulage d'un actionneur piézoélectrique selon l'une quelconque des revendications 1 à 18, **caractérisé en ce que** l'actionneur piézoélectrique est conçu sous forme de pièce moulée et une couche extérieure encapsulant l'actionneur piézoélectrique est déposée sur la pièce moulée.
